Europäisches Patentamt

European Patent Office

Office européen des brevets

(11) Veröffentlichungsnummer: **0 417 873 A1**

# (12) EUROPÄISCHE PATENTANMELDUNG

(21) Anmeldenummer: 90250224.4

(22) Anmeldetag: 08.09.90

(51) Int. Cl.⁵: **G01R 19/165, H02H 3/24**

(30) Priorität: **14.09.89 DE 3931063**

(43) Veröffentlichungstag der Anmeldung:
**20.03.91 Patentblatt 91/12**

(84) Benannte Vertragsstaaten:
**AT BE CH DE DK ES FR GB GR IT LI NL SE**

(71) Anmelder: **Siemens Aktiengesellschaft**
**Wittelsbacherplatz 2**
**W-8000 München 2(DE)**

(72) Erfinder: **Wenzel, Horst**
**Setheweg 31 B**
**W-1000 Berlin 22(DE)**

(54) Schaltungsanordnung zur Überwachung einer Stromversorgungseinrichtung auf Spannungsunterschreitung.

㊗ Bei einer bekannten Schaltungsanordnung dieser Art ist an die Primäreingänge der Stromversorgungseinrichtung eine Spannungsüberwachungseinrichtung angeschlossen, die mit einem Steuereingang mit einem Spannungserfassungswiderstand verbunden ist und mit ihrem Ausgang an einer Meldevorrichtung liegt.

Um auch Spannungen am Ausgang der stromversorgungseinrichtung (6) auf Unterschreiten eines vorgegebenen Wertes überwachen zu können, ist zwischen jeweils einem Ausgangsspannungskreis bildenden Ausgängen (30, 31, 32, 33) der Stromversorgungseinrichtung (6) eine Reihenschaltung (34; 35) aus einer Zenerdiode (42; 47), einer Stromregeldiode (38; 43) und einer Diodenstrecke (39; 44) eines Optokopplers angeschlossen. Dem Spannungserfassungswiderstand (18) ist ein elektronischer Schalter (51) parallelgeschaltet, der vom Ausgangsignal einer Steuerschaltung (55) mit der FototransistorStrecke (40; 45) des Optokopplers betätigbar ist.

# SCHALTUNGSANORDNUNG ZUR ÜBERWACHUNG EINER STROMVERSORGUNGSEINRICHTUNG AUF SPANNUNGSUNTERSCHREITUNG

Die Erfindung bezieht sich auf eine Schaltungsanordnung zur Überwachung einer Stromversorgungseinrichtung auf Spannungsunterschreitung mit einer an die Primäreingänge der Stromversorgungseinrichtung angeschlossenen Spannungsüberwachungseinrichtung, die mit einem Steuereingang mit einem an die Primäreingänge der Stromversorgungseinrichtung angeschlossenen Spannungserfassungswiderstand verbunden ist und an deren Ausgang eine Meldevorrichtung angeschlossen ist.

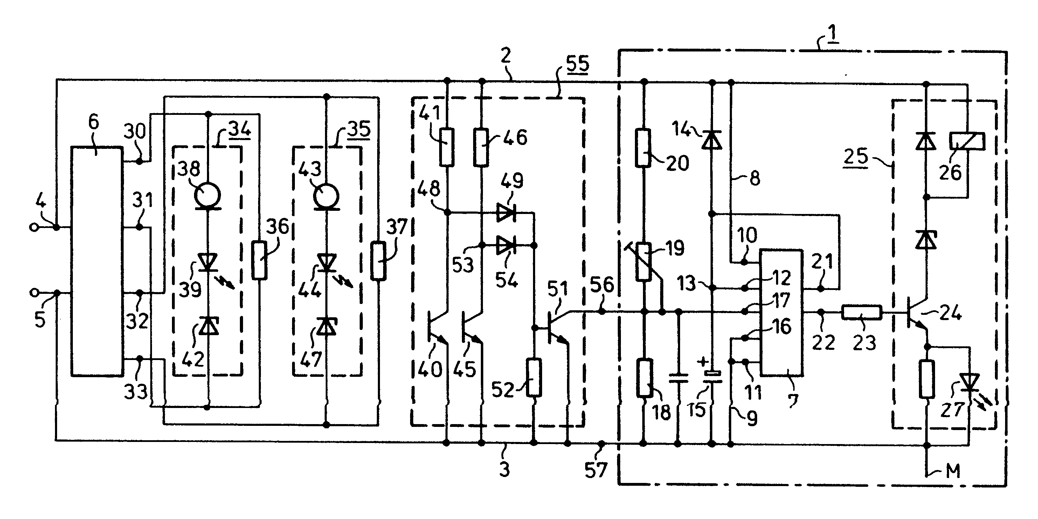

Eine bekannte Schaltungsanordnung dieser Art ist bei der Stromversorgung des Siemens-Umrichters 7TN39 offenkundig vorbenutzt. Der schaltungstechnische Aufbau dieser bekannten Schaltungsanordnung ist aus dem strichtpunktiert markierten Bereich der Figur zu entnehmen. Wie diese Figur im einzelnen erkennen läßt, ist die vorbenutzte Schaltungsanordnung 1 über Verbindungsleitungen 2 und 3 mit Primareingängen 4 und 5 einer Stromversorgungseinrichtung 6 verbunden. Die bekannte Schaltungungsanordnung 1 enthält eine spannungsüberwachungseinrichtung 7, die als integrierter Baustein in einer Weise ausgeführt ist, wie es beispielsweise dem Datenbuch Q 2/88 der Fa. Motorola, Seite 3.117 zu entnehmen ist. Die Spannungsüberwachungseinrichtung 7 ist über Verbindungsleitungen 8 und 9 hinsichtlich ihrer Stromversorgungseingänge 10 und 11 mit den Primäreingängen 4 und 5 der Stromversorgungseinrichtung 6 verbunden. Ein weiterer Eingangsanschluß 12 der Spannungsüberwachungseinrichtung 7 ist mit dem Verbindungspunkt 13 einer Reihenschaltung aus einer Diode 14 und einem Kondensator 15 verbunden; die Reihenschaltung aus Diode 14 und Kondensator 15 ist an die Primäreingänge 4 und 5 der Stromversorgungseinrichtung 6 angeschlossen. Ein weiterer Eingang 16 ist ebenfalls mit dem Kondensator 15 verbunden. Ein zusätzlicher Eingang der Spannungsüberwachungseinrichtung 7 bildet einen Steuereingang 17, der an einen Spannungserfassungswiderstand 18 angeschlossen ist. Dieser Spannungserfassungswiderstand 18 liegt in Reihe mit einem einstellbaren Widerstand 19 und einem Vorwiderstand 20 über die Verbindungsleitungen 2 und 3 ebenfalls an den Primäreingängen 4 und 5 der Stromversorgungseinrichtung 6.

Ein Ausgang 21 der Spannungsüberwachungseinrichtung 7 ist auf den Eingang 12 rückgeführt, während ein weiterer Ausgang 22 der Spannungsüberwachungseinrichtung 21 über einen Widerstand 23 mit dem Basisanschluß eines Transistors 24 in einer Meldevorrichtung 25 verbunden ist. Über den Transistor 24 ist einerseits ein Melderelais 26 steuerbar und andererseits eine Leuchtdiode 27 der Meldevorrichtung 25 erregbar.

Die bekannte Schaltungsanordnung 1 ist zur Überwachung der Spannung an den Primäreingängen 4 und 5 der Stromversorgungseinrichtung 6 geeignet. Liegt die Spannung an diesen Eingängen 4 und 5 über einer vorgegebenen Hohe, dann wird von der spannungsüberwachungseinrichtung 7 der Transistor 24 der Meldevorrichtung 25 so gesteuert, daß das Melderelais 26 angezogen ist und die Leuchtdiode 27 Licht abgibt. Unterschreitet die Spannung an den Primäreingangen 4 und 5 die vorgegebene, zulässige Höhe, die durch das Potentiometer 19 einstellbar ist, dann wird der Transistor 24 gesperrt, das Melderelais 26 fällt ab, und die Leuchtdiode 27 wird ebenfalls aberregt.

Der Erfindung liegt die Aufgabe zugrunde, die oben beschriebene, bekannte Schaltungsanordnung so fortzubilden, daß mit geringem schaltungstechnischem Aufwand auch die Ausgangsspannung der Stromversorgungseinrichtung auf Unterschreiten eines vorgegebenen Wertes überwacht werden kann.

Zur Lösung dieser Aufgabe ist bei der Schaltungsanordnung der oben angegebenen Art erfindungsgemäß zwischen jeweils einem Ausgangsspannungskreis der Stromversorgungseinrichtung zugehörigen Ausgängen eine Reihenschaltung aus einer Zenerdiode, einer Stromregeldiode und der Diodenstrecke eines Optokopplers angeschlossen, und dem Spannungserfassungswiderstand ist ein elektronischer Schalter parallelgeschaltet, der vom Ausgangssignal einer Steuerschaltung mit der Fototransistor-Strecke des Optokopplers betätigbar ist.

Der wesentliche Vorteil der erfindungsgemäßen Schaltungsanordnung besteht darin, daß allein durch die Reihenschaltung aus Zenerdiode, Stromregeldiode und Diodenstrecke in Kombination mit der Steuerschaltung die bekannte Schaltungsanordnung so fortentwickelt worden ist, daß mit ihr neben der Überwachung der Spannung an den Primäreingängen der Stromversorgungseinrichtung auch die Spannung an ihrem Ausgangskreis auf Unterschreiten vorgegebener Werte überwacht werden kann. Dabei ist die Erfindung unabhängig davon einsetzbar, wie viele Ausgangsspannungskreise die Stromversorgungseinrichtung hat; auch galvanisch miteinander verbundene oder galvanisch voneinander getrennte Ausgangsspannungskreise können mit der erfindungsgemäßen Schaltungsanordnung auf Unterschreiten vorgegebener Werte der Spannung überwacht werden.

Bei der erfindungsgemäßen Schaltungsanordnung kann die Steuerschaltung in unterschiedlicher Weise ausgebildet sein. Als besonders vorteilhaft wird es aber zur Erzielung eines möglichst einfachen schaltungstechnischen Aufbaus angesehen, wenn die Steuerschaltung in Reihe mit der FototransistorStrecke des Optokopplers einen Vorwiderstand enthält, daß die Anordnung aus Fototransistor-Strecke und Vorwiderstand an den Primäreingängen der Stromversorgungseinrichtung liegt, parallel zur Fototransistor-Strecke die Reihenanordnung einer Diode und eines Widerstandes liegt und der gemeinsame Verbindungspunkt von Diode und Widerstand der Reihenanordnung mit dem Steueranschluß des elektronischen Schalters verbunden ist.

Zur Erläuterung der Erfindung wird auf die oben bereits teilweise beschriebene Figur zurückgegriffen, und es werden nunmehr die Teile erläutert, die außerhalb des strichpunktierten, die Ausführung der bekannten Schaltungsanordnung wiedergebenden Bereichs liegen.

Bei der dargestellten Schaltungsanordnung in ihrer Gesamtheit ist an Ausgänge 30 und 31 bzw. 32 und 33 jeweils eines Ausgangsspannungskreises der stromversorgungseinrichtung 6 jeweils eine Reihenschaltung 34 bzw. 35 angeschlossen. Die übrigen Bestandteile der Ausgangsspannungskreise sind durch jeweils einen Ersatzwiderstand 36 bzw. 37 wiedergegeben. Die Reihenschaltung 34 besteht aus einer stromregeldiode 38, wie sie beispielsweise in dem "LOW POWER DISCRETES DATA BOOK" der Firma Siliconix, 1989 auf den Seiten 4-61 und 4-91 beschrieben ist. Ferner enthält die Reihenschaltung 34 die Diodenstrecke 39 eines Optokopplers, dessen Fototransistor-Strecke 40 in Reihe mit einem Vorwiderstand 41 zwischen die Verbindungsleitungen 2 und 3 geschaltet ist. Schließlich weist die Reihenschaltung 34 eine Zenerdiode 42 auf. Die Reihenschaltung 35 ist entsprechend aufgebaut, enthält also ebenfalls eine stromregeldiode 43, eine Diodenstrecke 44 eines weiteren Optokopplers, dessen Fototransistor-Strecke 45 in Reihe mit einem weiteren Vorwiderstand 46 zwischen den Verbindungsleitungen 2 und 3 liegt, und eine Zenerdiode 47.

Der Verbindungspunkt 48 von Vorwiderstand 41 und Fototransistor-Strecke 40 des einen Optokopplers ist über eine Diode 49 mit der Basis eines einen elektronischen Schalter bildenden Steuertransistors 51 verbunden; die Basis ist außerdem über einen Widerstand 52 nach Masse M geschaltet. Der Verbindungspunkt 53 von Vorwiderstand 46 und Fototransistor-Strecke 45 des weiteren Optokopplers ist über eine weitere Diode 54 ebenfalls mit der Basis des Steuertransistors 51 verbunden. Die Widerstände 41 sowie 46, Fototransistor-Strekken 40 und 45, die Dioden 49 und 54, der Steuertransistor 51 und der Widerstand 52 bilden eine Steuerschaltung 55, die mit ihren Ausgängen 56 und 57 parallel zum Spannungserfassungswiderstand 18 liegt.

Die dargestellte Schaltungsanordnung arbeitet hinsichtlich der Überwachung der Spannungen auf der Ausgangsseite der Stromversorgungseinrichtung 6 in folgender Weise:

Liegen die Spannungen zwischen den Ausgängen 30 und 31 sowie 32 und 33 der Stromversorgungseinrichtung 6 oberhalb eines zugelassenen unteren Wertes, der durch die Zenerdiode 42 bzw. 47 vorgegeben ist, dann wird von der Stromregeldiode 38 bzw. 43 ein eingeprägter Strom durch die Reihenschaltung 34 bzw. 35 getrieben. Dieser Strom veranlaßt die Diodenstrecke 39 bzw. 44 der Reihenschaltung 34 bzw. 35 zur Abgabe von Licht, wodurch die Fototransistor-Strecke 40 bzw. 45 in der Steuerschaltung 55 durchgesteuert wird. Dies wiederum führt dazu, daß der Steuertransistor 51 gesperrt wird. Ist die Spannung zwischen den Primlreingsngen 4 und 5 der Stromversorgungsrichtung 6 hoch genug, ist also das Melderelais 26 angezogen und die Leuchtdiode 27 erregt, dann sndert sich durch die in dem beschriebenen Zustand befindliche Steuerschaltung 55 daran nichts. Es wird von der Meldevorrichtung 25 signalisiert, daß sowohl auf der Eingangsseite als auch auf der Ausgangsseite der Stromversorgungseinrichtung 6 eine ausreichend hohe Spannung vorhanden ist.

Unterschreitet hingegen die Spannung zwischen den Ausgängen 30 und 31 bzw. 32 und 33 den vorgegebenen unteren Wert, dann sperrt die Zenerdiode 42 bzw. 47, und die Stromregeldiode 38 bzw. 43 läßt keinen Strom mehr durch die Dioden-Strecke 39 bzw. 44 der Optokoppler fließen. Damit wird die Fototransistor-Strecke 40 bzw. 45 in der Steuerschaltung 55 gesperrt, wodurch das Potential an der Basis des Steuertransistors 51 angehoben wird und der Steuertransistor 51 durchlässig wird. Dies führt zu einer Absenkung der Spannung am Spannungserfassungswiderstand 18, worauf die Spannungsüberwachungsschaltung 7 mit einem Sperren des Transistors 24 der Meldevorrichtung 25 reagiert.

Das Melderelais 26 fällt ab, und die Leuchtdiode 27 gibt kein Licht mehr ab. Damit ist signalisiert, daß die Stromversorgungseinrichtung 6 nicht einwandfrei arbeitet.

## Ansprüche

1. Schaltungsanordnung zur Überwachung einer Stromversorgungseinrichtung (6) auf Spannungsunterschreitung mit
a) einer an die Primäreingänge (4, 5) der Stromversorgungseinrichtung (6) angeschlossenen Spannungsüberwachungseinrichtung (7), die

a1) mit einem Steuereingang (17) mit einem an die Primäreingänge (4, 5) der Stromversorgungseinrichtung (6) angeschlossenen Spannungserfassungswiderstand (18) verbunden ist und

a2) an deren Ausgang (22) eine Meldevorrichtung angeschlossen ist,

**dadurch gekennzeichnet, daß**

b) zwischen jeweils einem Ausgangsspannungskreis der Stromversorgungseinrichtung (6) zugehörigen Ausgangen (30, 31; 32, 33) eine Reihenschaltung (34; 35) aus einer Zenerdiode (42; 47), einer stromregeldiode (38; 43) und einer Diodenstrecke (39; 44) eines Optokopplers angeschlossen ist und daß

c) dem Spannungserfassungswiderstand (18) ein elektronischer Schalter (51) parallelgeschaletet ist, der vom Ausgangssignal einer Steuerschaltung (55) mit der FototransistorStrecke (40; 45) des Optokopplers betätigbar ist.

2. Schaltungsanordnung nach Anspruch 2,
**dadurch gekennzeichnet, daß**

d) die Steuerschaltung (55) in Reihe mit der FototransistorStrecke (40; 45) des Optokopplers einen Vorwiderstand (41; 46) enthält, daß

e) die Anordnung aus Fototransistor-Strecke (40; 45) und Vorwiderstand (41; 46) an den Primäreingängen (4, 5) der Stromversorgungseinrichtung (6) liegt, daß

f) parallel zur Fototransistor-Strecke (40; 45) die Reihenschaltung einer Diode (49; 54) und eines Widerstandes (41; 46) liegt und daß

g) der gemeinsame Verbindungspunkt (48; 53) von Diode (49; 54) und Widerstand (41; 46) der Reihenanordnung mit dem Steueranschluß des elektronischen Schalters (51) verbunden ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.⁵) |
|---|---|---|---|
| A | <u>DE - A1 - 3 111 851</u><br>(OELSCH)<br>* Zusammenfassung *<br>---- | | G 01 R 19/165<br>H 02 H   3/24 |

|  | RECHERCHIERTE SACHGEBIETE (Int. Cl.⁵) |
|---|---|
|  | G 01 R 19/00<br>H 02 H   3/00 |

Der vorliegende Recherchenbericht wurde für alle Patentansprüche erstellt.

| Recherchenort | Abschlußdatum der Recherche | Prüfer |
|---|---|---|
| WIEN | 20-12-1990 | KUNZE |

KATEGORIE DER GENANNTEN DOKUMENTEN
X : von besonderer Bedeutung allein betrachtet
Y : von besonderer Bedeutung in Verbindung mit einer anderen Veroffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veroffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82